# EUROPEAN PATENT SPECIFICATION

(11) **EP 4 303 672 B1**
(45) Date of publication and mention of the grant of the patent: **22.04.2026**
(21) Application number: 23183841.8
(22) Date of filing: 06.07.2023
(51) Int. Cl.: G06N 20/00, G05B 17/02

(54) **EVALUATION MODEL GENERATING APPARATUS, EVALUATION MODEL GENERATING METHOD, AND EVALUATION MODEL GENERATING PROGRAM**
VORRICHTUNG ZUR ERZEUGUNG EINES AUSWERTUNGSMODELLS, VERFAHREN ZUR ERZEUGUNG EINES AUSWERTUNGSMODELLS UND PROGRAMM ZUR ERZEUGUNG EINES AUSWERTUNGSMODELLS
APPAREIL DE GÉNÉRATION DE MODÈLE D'ÉVALUATION, PROCÉDÉ DE GÉNÉRATION DE MODÈLE D'ÉVALUATION ET PROGRAMME DE GÉNÉRATION DE MODÈLE D'ÉVALUATION

(30) Priority: 08.07.2022 JP 2022110309
(43) Date of publication of application: 10.01.2024
(73) Proprietor: Yokogawa Electric Corporation, Musashino-shi, Tokyo 180-8750 (JP)
(72) Inventor: JINGUU, Yoshiyuki, Tokyo, 180-8750 (JP); OKAMOTO, Hiromi, Tokyo, 180-8750 (JP); MITOMO, Nobuhiro, Tokyo, 180-8750 (JP); TAKAMI, Go, Tokyo, 180-8750 (JP); SATO, Masahiko, Tokyo, 180-8750 (JP); FUJII, Hideyuki, Tokyo, 180-8750 (JP)
(74) Representative: Hoffmann Eitle

(56) References cited:
- EP-A1- 3 958 271
- EP-A1- 3 985 460
- WO-A1-2021/011759
- US-A1- 2019 120 810

## Description

### BACKGROUND

### 1. TECHNICAL FIELD

The present invention relates to an evaluation model generating apparatus, an evaluation model generating method, and an evaluation model generating program.

### 2. RELATED ART

Patent Document 1 describes that "a model 45 outputs a recommended control parameter indicating a content of a first type of control recommended to increase a reward value according to an input of measurement data". Non-Patent Document 1 describes about "factorial kernel dynamic policy programming (FKDPP)".

Patent Document 2 relates to methods for analysis of crude oil components using evaporative light scattering detection.

Patent Document 3 relates to hydrocarbon fluid properties prediction using machine learning-based models.

### PRIOR ART DOCUMENTS

### PATENT DOCUMENT

Patent Document 1: Japanese Patent Application Publication No. 2021-086283
Patent Document 2: WO 2021/011759 A1
Patent Document 3: EP 3 958 271 A1

### NON-PATENT DOCUMENT

Non-Patent Document 1: "Yokogawa Electric and NAIST conduct reinforcement learning for chemical plants", Nikkei Robotics, March 2019.

### SUMMARY

The invention is defined by the independent claims.

### BRIEF DESCRIPTION OF THE DRAWINGS

Fig. 1 illustrates one example of a block diagram of an evaluation model generating apparatus 100 according to the present embodiment, together with equipment 10.
Fig. 2 illustrates one example of an oil refinement flow in an oil refinery that is one example of the equipment 10.
Fig. 3 illustrates one example of correspondence between a raw material and an evaluation model.
Fig. 4 illustrates one example of a flow diagram of an evaluation model generating method performed by the evaluation model generating apparatus 100 according to the present embodiment.
Fig. 5 illustrates examples of data space of property data and a dendrogram before a crude oil E is added.
Fig. 6 illustrates examples of data space of property data and a dendrogram after the crude oil E is added.
Fig. 7 illustrates one example of a block diagram of an evaluation model generating apparatus 100 according to a first modified example of the present embodiment, together with equipment 10.
Fig. 8 illustrates one example of a block diagram of an evaluation model generating apparatus 100 according to a second modified example of the present embodiment, together with equipment 10.
Fig. 9 illustrates an example of a computer 9900 in which a plurality of aspects of the present invention may be entirely or partially embodied.

### DESCRIPTION OF EXEMPLARY EMBODIMENTS

Hereinafter, embodiments of the present invention will be described.

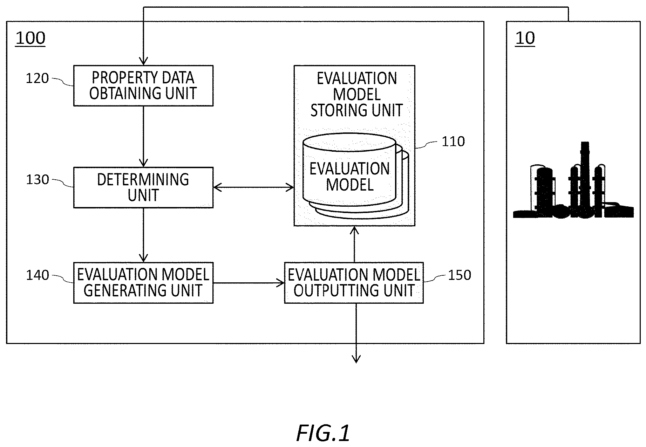

Fig. 1 illustrates one example of a block diagram of an evaluation model generating apparatus 100 according to the present embodiment, together with equipment 10. Note that, these blocks are functional blocks that are each functionally divided, and may not be necessarily required to be identical to those of actual apparatus structure. That is, in the present drawing, an apparatus indicated by one block may not be necessarily required to be composed of one apparatus. In addition, in the present drawing, apparatuses indicated by separate blocks may not be necessarily required to be composed of separate apparatuses. The same applies to subsequent block diagrams.

The equipment 10 is a (group of) apparatus(es) for manufacturing a product from a raw material. For example, the equipment 10 may be a plant or a complex apparatus in which a plurality of devices is combined. Examples of the plant may include a plant for managing and controlling wells such as a gas field and an oilfield and surroundings thereof, a plant for managing and controlling hydroelectric, thermo electric and nuclear power generations and the like, a plant for managing and controlling environmental power generation such as solar power and wind power, a plant for managing and controlling water and sewerage, a dam and the like, and the like, in addition to chemical and bio industrial plants and the like.

The equipment 10 may be provided with various control targets, and one or more sensors that can measure various states, i.e., physical quantities, inside and outside the equipment 10. By way of example, such a sensor may output process variables (PVs) obtained by measuring temperatures at various positions of the equipment 10, or flow rates in various paths, or the like. State data representing a state of the equipment 10 may include such a process variable (PV). Also, the state data may include a manipulated variable (MV) representing an open/close degree etc. of a control target, e.g., a valve. The state data may also include, in addition to running data representing a running state as a result of controlling the control target as mentioned above, consumption amount data representing a consumption amount of energy or raw materials in the equipment 10, external disturbance environmental data representing a physical quantity that can act as an external disturbance to control of the control target, or the like.

Here, in operating the equipment 10, it is desired to properly evaluate the state of the equipment 10 in light of operational goals. In evaluating the state of the equipment 10, it can be considered to use an evaluation model that is machine-learned to output an indicator obtained by evaluating a state of the equipment 10 in response to state data representing the state of the equipment 10 being input.

Assuming that the equipment 10 is, for example, an oil refinery for refining crude oil and thereby manufacturing (producing) a plurality of petroleum products. In this case, a raw material to be used in the equipment 10 includes at least the crude oil. However, it is known that properties of crude oil vary greatly depending on its region of production or time of production. Note that, the term "property" may be construed to mean at least one of a characteristic or a state of an object. Such differences in properties cause differences in reaction, corrosiveness, toxicity, and the like, as well as changes in products suitable for manufacturing, differences in qualities of products, and the like.

For the operational goals of the equipment 10, a plurality of items can be set, such as quality assurance, energy conservation, greenhouse gas (GHG) reduction, yield improvement, and the like, and a target value for each of the items can also be set variably. In setting such operational goals, it is ideal to optimize the setting for every type of crude oil. That is, it is ideal to generate an evaluation model for the every type of crude oil. However, if a new evaluation model is generated every time a region of production of the crude oil or time of production of the crude oil changes, a processing load increases due to an increase in frequency of machine learning, and time loss occurs because a new evaluation model needs to be generated before starting an operation of the equipment 10.

Therefore, in generating an evaluation model for evaluating a state of the equipment 10, the evaluation model generating apparatus 100 according to the present embodiment determines whether to generate the evaluation model based on property data representing a property of a raw material, and generates the evaluation model by machine learning according to a result of the determining.

Hereinafter, a case will be described by way of example, in which the equipment 10 is an oil refinery. The equipment 10 may be any (group of) apparatus(es) that can manufacture a product from a raw material, but it is particularly preferable if it is a (group of) apparatus(es) in which a property of the raw material has a relatively large impact on its operation. Examples of such equipment 10 include a coal-fired power plant in which sulfur content of coal can have a large impact on a degree of combustion, a water treatment plant in which liquid quality of raw water can have a large impact on an amount of chemicals dropped, and the like. For example, if the equipment 10 is a thermal power plant, the raw material may include fossil fuel such as petroleum, coal, and natural gas, and water, and the product may be electricity. Also, for example, if the equipment 10 is the water treatment plant, the raw material may include at least raw water such as river water, and the product may be purified water. As mentioned above, the equipment 10 is not limited in any way to any industry, size, etc.

The evaluation model generating apparatus 100 may be a computer such as a personal computer (PC), tablet computer, smartphone, workstation, server computer, or general purpose computer, or may be a computer system to which a plurality of computers are connected. Such a computer system is also a computer in a broad sense. In addition, the evaluation model generating apparatus 100 may also be implemented by one or more virtual computer environments that can be executed in the computer. Instead of this, the evaluation model generating apparatus 100 may also be a dedicated computer designed for generation of an evaluation model or may also be dedicated hardware implemented by a dedicated circuit. In addition, when connectable to the Internet, the evaluation model generating apparatus 100 may be actualized by cloud computing.

The evaluation model generating apparatus 100 includes an evaluation model storing unit 110, a property data obtaining unit 120, a determining unit 130, an evaluation model generating unit 140, and an evaluation model outputting unit 150.

The evaluation model storing unit 110 stores an evaluation model. For example, the evaluation model storing unit 110 may associate one or more evaluation models with the raw material to be used in the equipment 10, and store the associated evaluation model(s). More specifically, the evaluation model storing unit 110 may store an evaluation models for each of one or more clusters in which the raw materials are clustered. This will be described below in detail. At this time, the evaluation model storing unit 110 can store an evaluation model generated by another apparatus in addition to the evaluation model generated in its own apparatus, i.e., in the evaluation model generating unit 140 to be described below.

The property data obtaining unit 120 obtains property data representing a property of a raw material to be used in the equipment 10 for manufacturing a product from the raw material. For example, the property data obtaining unit 120 may obtain such property data from the equipment 10 via a network. The property data obtaining unit 120 can obtain the property data through another means, such as a user input, various memory devices, or the like, or from another apparatus different from the equipment 10. The property data obtaining unit 120 supplies the determining unit 130 with the obtained property data.

The determining unit 130 determines, based on the property data, whether to generate an evaluation model for outputting an indicator obtained by evaluating a state of the equipment 10. For example, the determining unit 130 may determine, by referring to the property data stored in the evaluation model storing unit 110, and based on the property data obtained by the property data obtaining unit 120, whether to generate the evaluation model. The determining unit 130 supplies the evaluation model generating unit 140 with a result of the determining, together with the property data obtained by the property data obtaining unit 120.

The evaluation model generating unit 140 generates, according to the result of the determining, an evaluation model through machine learning. The evaluation model generating unit 140 supplies the evaluation model outputting unit 150 with a new evaluation model generated, together with the property data obtained by the property data obtaining unit 120.

The evaluation model outputting unit 150 outputs the evaluation model. For example, the evaluation model outputting unit 150 may output the evaluation model generated by the evaluation model generating unit 140 by transmitting the same to another apparatus via a network. The evaluation model outputting unit 150 can output the generated evaluation model by writing it to various memory devices, or by displaying it on a monitor.

In addition, the evaluation model outputting unit 150 may supply the evaluation model storing unit 110 with the generated evaluation model together with the property data obtained by the property data obtaining unit 120. In response to this, the evaluation model storing unit 110 may associate the generated evaluation model with the raw material, and newly store the associated evaluation model.

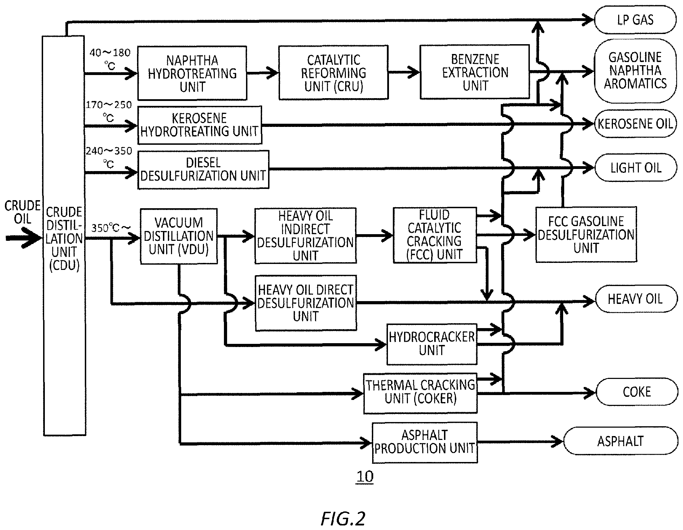

Fig. 2 illustrates one example of an oil refinement flow in an oil refinery that is one example of the equipment 10. In the oil refinery, crude oil, which is a mixture of hydrocarbons in a wide range of boiling ranges, is refined and thereby a plurality of petroleum products is produced. Generally, in the oil refinery, crude oil is distilled in a crude distillation unit (CDU), and separated into fractions in different boiling ranges depending on cutting temperatures, i.e., a gas fraction, naphtha fraction, kerosene fraction, light oil fraction, heavy oil fraction, and residual fraction. LP gas is produced from the gas fraction. The naphtha fraction is hydro-desulfurized by a naphtha hydrotreating unit and then catalytically reformed by a catalytic reforming unit (CRU), and benzene is separated therefrom by a benzene extraction unit to produce gasoline, naphtha, aromatics, and the like. The kerosene fraction is hydro-desulfurized in a kerosene hydrotreating unit to produce kerosene oil. The light oil fraction is desulfurized in a diesel desulfurization unit to produce light oil. The heavy oil fraction is hydro-desulfurized in a heavy oil direct desulfurization unit to produce heavy oil. Also, the heavy oil fraction is separated into light and heavy fractions in a vacuum distillation unit (VDU). The light fraction separated in the VDU is catalytically cracked in a fluid catalytic cracking (FCC) unit after hydro-desulfurized in a heavy oil indirect desulfurization unit, and then hydro-desulfurized in an FCC gasoline desulfurization unit to produce gasoline. Alternatively, the light fraction separated in VDU is processed in a hydrocracker unit (HCU). On the other hand, the heavy fraction separated in VDU is pyrolyzed in a thermal cracking unit (Coker) to produce coke, and is also processed in an asphalt production unit to produce asphalt.

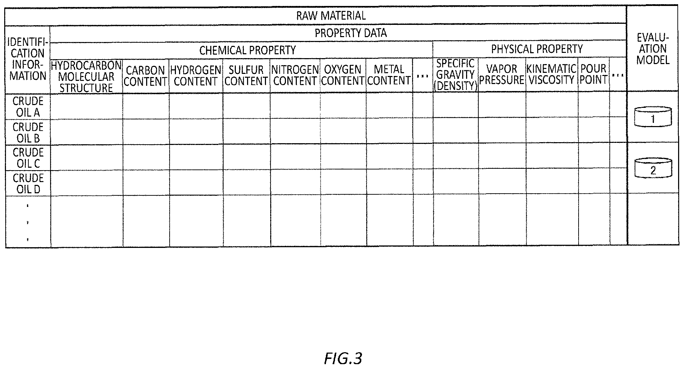

Fig. 3 illustrates one example of correspondence between a raw material and an evaluation model. In the present drawing, a case is shown by way of example in which the raw material includes at least crude oil. However, the raw material is not limited to include this. For example, the raw material may include at least one of fossil fuel or water. For example, as shown in the present drawing, the evaluation model storing unit 110 may associate one or more evaluation models with data representing a raw material to be used in the equipment 10, and store the associated evaluation model(s).

For example, the data representing the raw material may be composed of identification information which identifies the raw material, and property data representing a property of the raw material.

By way of example, in the present drawing, four pieces of identification information being crude oil A, crude oil B, crude oil C, and crude oil D are shown as the identification information which identifies the raw material. Here, crude oils identified by the crude oil A, crude oil B, crude oil C, and crude oil D may be those that have been used in the past in the equipment 10, and for example, at least one of regions of production or time of production of the crude oils may be different from each other.

The property data representing the property of the raw material may have data representing at least one of a chemical property or a physical property of the crude oil. In the present drawing, a case is shown by way of example in which the property data has both of the chemical property and the physical property.

Crude oil is a natural product of which main component is hydrocarbons. Crude oils are variously classified into, depending on types of molecular structure of hydrocarbons being their main component, a crude oil containing large amounts of paraffinic hydrocarbons (called "paraffin-based crude oil"), a crude oil containing large amounts of naphthenic hydrocarbons (called "naphthenic-based crude oil"), a crude oil intermediate between paraffin-based crude oil and naphthenic-based crude oil (called "mixed-base crude oil", a crude oil containing large amounts of aromatic hydrocarbons (called "special crude oil"), and the like.

Here, each type of the molecular structure of hydrocarbons has different product suitable for production, such that the paraffin-based crude oil is suitable for a lubricant and a wax, the naphthenic-based crude oil is suitable for gasoline and asphalt, the mixed-base crude oil is suitable for kerosene oil, lubricant, and heavy oil, the special crude oil is suitable for gasoline and a solvent, and so on. Therefore, it is particularly preferable if the chemical property includes a type of molecular structure of hydrocarbons.

In addition to the hydrocarbons being the main component of crude oil, the crude oil contains trace amounts of sulfur, nitrogen, oxygen, metal, etc. A composition (by mass percent) of crude oil is generally in a range of: 83% to 87% carbon; 11% to 14% hydrogen, 5% or less sulfur; 0.4% or less nitrogen; 0.5% or less oxygen, and 0.5% or less metal.

Here, the sulfur, nitrogen, oxygen, and metal, which are less abundant than carbon and hydrogen in quantity, have a large impact on petroleum refining and petroleum product quality. For example, the sulfur can become sulfurous dioxide gas upon combustion, and cause degradation of a petroleum product, corrosion of an apparatus, catalytic poisoning, etc. Also, the metal (especially heavy metals) can be a catalytic poison for a plant. Therefore, it is particularly preferable if the chemical property includes at least any of a carbon content, hydrogen content, sulfur content, nitrogen content, oxygen content, or metal content.

Crude oils are also variously classified into, depending on their specific gravities, an extra light crude oil, light crude oil, medium crude oil, heavy crude oil, extra heavy crude oil, and the like. Note that, the term "specific gravities" used herein may be construed to include "densities", which is equivalent in values. From the viewpoint of crude oil storage and control, a vapor pressure, kinematic viscosity, pour point, and the like are also important items. Therefore, it is particularly preferable if the physical property includes at least any of the specific gravity, vapor pressure, kinematic viscosity, or pour point.

In the present drawing, a case is shown by way of example in which, based on the property data representing such a chemical property and physical property, the crude oil A and the crude oil B are clustered into the same cluster 1, the crude oil C and the crude oil D are clustered in the same cluster 2, and an evaluation model 1 is associated with the cluster 1, and an evaluation model 2 is associated with the cluster 2. This means that the evaluation model 1 is used for evaluating a state of the equipment 10 when the crude oil A or the crude oil B is used in the equipment 10, and the evaluation model 2 is used for evaluating a state of the equipment 10 when the crude oil C or the crude oil D is used in the equipment 10.

For example, if a crude oil E is used as a target raw material to be used in the equipment 10 under such circumstances, the evaluation model generating apparatus 100 according to the present embodiment determines whether to generate an evaluation model based on a property data of the crude oil E, and generates the evaluation model by machine learning according to a result of the determining. This will be described in detail by using a flow.

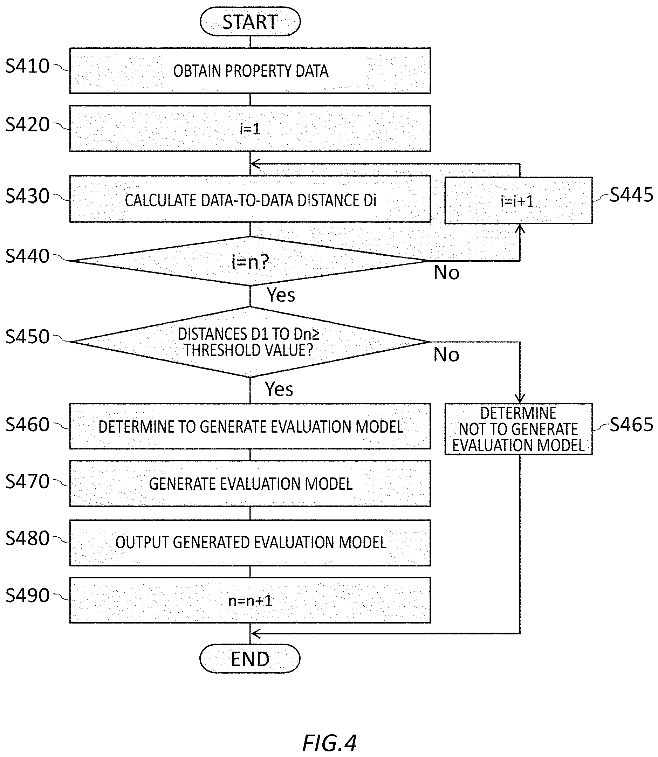

Fig. 4 illustrates one example of a flow diagram of an evaluation model generating method performed by the evaluation model generating apparatus 100 according to the present embodiment. Before performing this flow, it is assumed that, as shown in Fig. 3, the evaluation model storing unit 110 has stored the evaluation model 1 corresponding to the cluster 1 and the evaluation model 2 corresponding to the cluster 2 in advance.

In step S410, the evaluation model generating apparatus 100 obtains property data. For example, the property data obtaining unit 120 may obtain property data representing a property of a raw material to be used in the equipment 10, which manufactures a product from the raw material, from the equipment 10 via a network. By way of example, the property data obtaining unit 120 may obtain property data Pe representing a property of the crude oil E being the target raw material to be used in the equipment 10.

As described above, the property data Pe may have data representing at least one of the chemical property, or physical property of the crude oil E. Also, it is particularly preferable if the chemical property includes a type of molecular structure of hydrocarbons, and at least any of a carbon content, hydrogen content, sulfur content, nitrogen content, oxygen content, or metal content. Further, it is particularly preferable if the physical property includes at least any of a specific gravity, vapor pressure, kinematic viscosity, or pour point. Here, it is assumed that the property data Pe has data representing all of the items described above. The property data obtaining unit 120 supplies the determining unit 130 with the obtained property data Pe.

In step S420, the evaluation model generating apparatus 100 sets i=1. Here, i represents an index of a cluster. In this manner, the evaluation model generating apparatus 100 initializes the index of the cluster.

In step S430, the evaluation model generating apparatus 100 calculates a data-to-data distance Di. For example, the determining unit 130 may calculate the data-to-data distance Di between the property data Pe obtained in step S410 and a cluster i. At this time, by way of example, the determining unit 130 may calculate the distance Di by averaging distances between the property data Pe and all pieces of property data of raw materials clustered in the cluster i. Note that, in the description described above, the case has been shown by way of example in which the determining unit 130 calculates the distance Di by using a group average method, but the calculating method is not limited to this. For example, the determining unit 130 may calculate the distance Di by using another method, such as the Ward's method.

By way of example, if i=1, the determining unit 130 may calculate the data-to-data distance D1 between the property data Pe and the cluster 1 by calculating each of a data-to-data distance Dae, which is between the property data Pe representing the property of the crude oil E and property data Pa representing a property of the crude oil A that is clustered in the cluster 1, and a data-to-data distance Dbe, which is between the property data Pe representing the property of the crude oil E and property data Pb representing a property of the crude oil B that is clustered in the cluster 1, and averaging the distance Dae and the distance Dbe.

In step S440, the evaluation model generating apparatus 100 determines whether i=n. Here, n represents a maximum value of an index of a cluster. For example, when the evaluation model storing unit 110 has stored the evaluation model 1 corresponding to the cluster 1, and the evaluation model 2 corresponding to the cluster 2, then n=2. If i=1, then because it is not i=n (i.e., No), the evaluation model generating apparatus 100 causes the processing to proceed to step S445.

In step S445, the evaluation model generating apparatus 100 sets i = i + 1. In this manner, the evaluation model generating apparatus 100 increments the index of the cluster. Then, the evaluation model generating apparatus 100 causes the processing to return step 430 and continues the flow.

In step S430, if i=2, the determining unit 130 may calculate a data-to-data distance D2 between the property data Pe and the cluster 2 by calculating each of a data-to-data distance Dce, which is between the property data Pe representing the property of the crude oil E and property data Pc representing a property of the crude oil C that is clustered in the cluster 2, and a data-to-data distance Dde, which is between the property data Pe representing the property of the crude oil E and property data Pd representing a property of the crude oil D that is clustered in the cluster 2, and averaging the distance Dce and the distance Dde.

In step S440, if i=2, then because it is i=n (i.e., Yes), the evaluation model generating apparatus 100 causes the processing to proceed to step S450.

In step S450, the evaluation model generating apparatus 100 determines whether the distance D1 to distance Dn are equal to or greater than a threshold value. For example, the determining unit 130 may compare each of the distance D1 and the distance D2 calculated by repeating the processing from step S430 to step S445 from i=1 to i=2, with a predetermined threshold value. Then, if both of the distance D1 and the distance D2 are equal to or greater than the threshold value (i.e., Yes), the determining unit 130 may cause the crude oil E being the target raw material to be clustered into a cluster 3 that is different from the cluster 1 and the cluster 2. In this manner, the determining unit 130 may judge that the crude oil E being the target raw material is not similar in property to any of the crude oil A to crude oil D, which are raw materials that have been used in the past. Note that, the term "similar" can be construed to include being the same, in addition to being alike. The evaluation model generating apparatus 100 causes the processing to proceed to step S460.

In step S460, the evaluation model generating apparatus 100 determines to generate an evaluation model. For example, the determining unit 130 may determine to generate an evaluation model that corresponds to the crude oil E being the target raw material. In this manner, the determining unit 130 may determine to generate the evaluation model if it is judged that the target raw material is not similar in property to the raw material that has been used in the past based on the property data. The determining unit 130 supplies the evaluation model generating unit 140 with a result of the determining, together with the property data Pe.

In step S470, the evaluation model generating apparatus 100 generates the evaluation model. For example, the evaluation model generating unit 140 may generate an evaluation model which outputs an indicator obtained by evaluating a state of the equipment 10. By way of example, the evaluation model generating unit 140 may obtain an operational goal such as a plant key performance indicator (KPI) in the equipment 10, state data representing a state of the equipment 10, and a teacher label, and generate labeling data based thereon. Then, the evaluation model generating unit 140 may use the generated labeling data as learning data, and generate the evaluation model by a machine learning algorithm. Generation processing itself of the evaluation model may be arbitrarily performed, and thus further details are omitted from description herein. In this manner for example, the evaluation model generating unit 140 may generate an evaluation model 3 corresponding to the cluster 3 by machine learning, according to the result of the determining. The evaluation model generating unit 140 supplies the evaluation model outputting unit 150 with the generated evaluation model 3, together with the property data Pe.

In step S480, the evaluation model generating apparatus 100 outputs the generated evaluation model. For example, the evaluation model outputting unit 150 may transmit the evaluation model 3 generated in step S470 to another apparatus via a network.

Here, a technique in which a control apparatus controls the control target in the equipment 10 by using the operation model which outputs an action corresponding to the state of the equipment 10 is known as, so-called artificial intelligence (AI) control. It can be considered that an operation model generating apparatus generates an operation model to be used in the Al control by reinforcement learning, in which an output of an evaluation model is treated as at least a part of a reward. Therefore, the evaluation model outputting unit 150 may transmit the generated evaluation model 3 to such an operation model generating apparatus. Accordingly, the operation model generating apparatus may generate an operation model which outputs an action corresponding to a state of the equipment 10 by reinforcement learning, in which an output of an evaluation model is treated as at least a part of a reward. Then, the operation model generating apparatus may transmit the generated operation model to the control apparatus. In response to this, the control apparatus may control a control target provided in the equipment 10 by using the operation model, that is, perform the Al control.

In addition, the evaluation model outputting unit 150 may supply the evaluation model storing unit 110 with the evaluation model 3 generated in step S470, together with the property data Pe. In response to this, the evaluation model storing unit 110 may associate the evaluation model 3 corresponding to the cluster 3 with the property data of the crude oil E, and newly store the associated evaluation model.

In step S490, the evaluation model generating apparatus 100 sets n = n +1. In this manner, the evaluation model generating apparatus 100 increments a maximum value of an index of a cluster.

On the other hand, in step S450, the evaluation model generating apparatus 100 may judge, if any of the distance D1 to the distance Dn is not equal to or greater than the threshold value (i.e., No), that the crude oil E being the target raw material has a property similar to any properties of the crude oil A to crude oil D, which are raw materials that have been used in the past. The evaluation model generating apparatus 100 causes the processing to proceed to step S465.

In step S465, the evaluation model generating apparatus 100 determines not to generate an evaluation model. For example, the determining unit 130 may determine not to generate an evaluation model corresponding to the crude oil E being the target raw material, and instead, to reuse an evaluation model corresponding to a raw material that has been used in the past. In this manner, the determining unit 130 may determine not to generate the evaluation model if it is judged, that the target raw material has a property similar to a property of a raw material that has been used in the past based on the property data. In that case, the evaluation model generating apparatus 100 omits step S470 to step S490, and ends the flow without performing the processing that relates to generation of the evaluation model.

Note that, at this time, the evaluation model generating apparatus 100 may output the evaluation model to be reused, or information for identifying this evaluation model. By way of example, the determining unit 130 may supply, if it is determined not to generate an evaluation model, the evaluation model generating unit 140 with an index of a cluster having the smallest distance among the distance D1 to the distance Dn, as a determination result. Then, the evaluation model generating unit 140 may forward this index of the cluster to the evaluation model outputting unit 150. In response to this, the evaluation model outputting unit 150 may read out an evaluation model corresponding to the cluster indicated by the index from the evaluation model storing unit 110, and output this evaluation model. Instead of this, the evaluation model outputting unit 150 may output, not the evaluation model itself, but information for identifying the evaluation model, e.g., an index of a cluster.

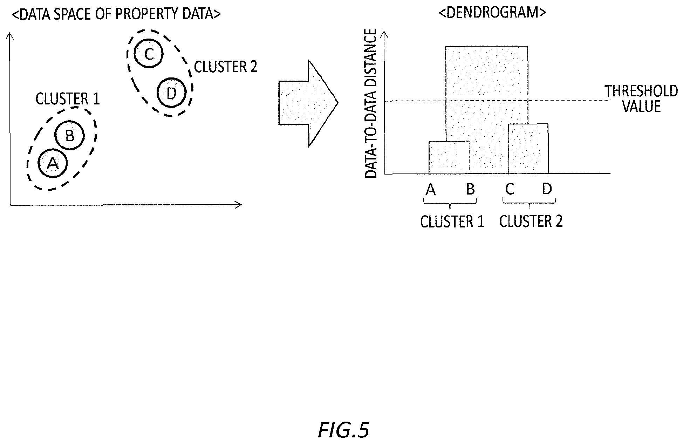

Fig. 5 illustrates examples of data space of property data and a dendrogram before the crude oil E is added. Hereinafter, a case will be described by way of example, in which the evaluation model generating apparatus 100 uses hierarchical clustering in clustering the property data. Using the hierarchical clustering is preferable because its processing is relatively simple, and processes of classification can be clarified. The evaluation model generating apparatus 100 can use non-hierarchical clustering such as the k-means method, k-means++ method, or x-means method in clustering the property data.

The data space of the property data is shown on the left side of this drawing. As shown on the left side of this drawing, the crude oil A and the crude oil B are clustered into the cluster 1, and the crude oil C and the crude oil D are clustered into the cluster 2.

The dendrogram is shown on the right side of this drawing. A dendrogram is a representation of a way individuals are grouped into clusters in a clustering process in a form of a tree diagram. According to the dendrogram, it can be understood that the crude oil A and the crude oil B are clustered into the same cluster because a data-to-data distance between them is close (less than a threshold value), and the crude oil C and the crude oil D are clustered into the same cluster because a data-to-data distance between them is close. On the other hand, because a data-to-data distance between the crude oils A and B and the crude oils C and D is far away (threshold value or more) from each other, they are clustered into different clusters. In clustering the property data, the determining unit 130 may visualize processes in which these clusters are formed, by outputting (e.g., displaying it on a monitor) such a dendrogram.

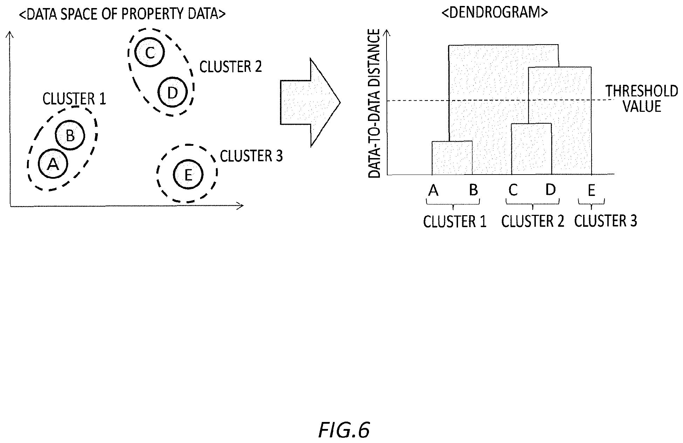

Fig. 6 illustrates examples of data space of property data and a dendrogram after the crude oil E is added. In Fig. 6, members having the same functions and structure as those in Fig. 5 are denoted by the same reference numerals, and description thereof will be omitted except for differences.

According to the dendrogram, it can be understood that, because a data-to-data distance between the crude oil E and the cluster 1 is far away (threshold value or more) from each other, and a data-to-data distance between the crude oil E and the cluster 2 is also far away from each other, the crude oil E is clustered into the cluster 3 different from the cluster 1 and the cluster 2. In this manner, if a data-to-data distance between property data of a target raw material and any one or more clusters, in which property data of raw materials that have been used in the past are grouped by hierarchical clustering, is a predetermined threshold value or more, the determining unit 130 may cause the target raw material to be clustered into a cluster different from existing clusters, and judge that the target raw material is not similar in property to the raw material that has been used in the past.

Note that, in Figs. 5 and 6, the cases are shown by way of example in which the evaluation model generating apparatuses 100 use the hierarchical clustering in clustering the property data. However, as described above, an evaluation model generating apparatus 100 may use non-hierarchical clustering in clustering the property data. That is, the determining unit 130 may judge, if a target raw material belongs in a cluster different from that of a raw material that has been used in the past as a result of clustering the property data, that the target raw material is not similar in property to the raw material that has been used in the past, and the clustering method itself is not limited in any way.

In the equipment 10, if a plurality of raw materials, which are identified by regions of production, time of production, or the like, is used, generating one evaluation model for every raw material increases processing load and causes time loss too. In contrast to this, the evaluation model generating apparatus 100 according to the present embodiment determines, in generating an evaluation model, whether to generate the evaluation model based on the property data that represents a property of a raw material, and generates the evaluation model by machine learning according to a result of the determining. In this manner, the evaluation model generating apparatus 100 according to the present embodiment can provide a trigger for machine learning for generating the evaluation model, according to an objective determination result of whether to generate the evaluation model. Therefore, since the evaluation model generating apparatus 100 according to the present embodiment does not generate one evaluation model for every raw material, but instead generates an evaluation model only when determined as necessary in consideration of a property of the raw material, processing load can be reduced while frequency of time loss occurrence can be lessened also.

The evaluation model generating apparatus 100 according to the present embodiment may determine, if it is judged that a target raw material is not similar in property to a raw material that has been used in the past based on property data, to generate an evaluation model. In this manner, the evaluation model generating apparatus 100 according to the present embodiment can determine whether to generate an evaluation model, based on whether properties of raw materials are similar to each other. Therefore, with the evaluation model generating apparatus 100 according to the present embodiment, a case can be avoided in which, a new evaluation model is generated even when a target raw material has a property similar to a property of a raw material that has been used in the past and thus reusing an existing evaluation model does not have a large impact on evaluating the equipment 10.

Specifically, it can be considered to uniformly determine whether to generate an evaluation model depending on differences in regions of production or time of production. However, there may be a case in which even if the regions of production or the time of production are far away from each other, properties of raw materials are similar to one another, and a case in which even if the regions of production or time of production are close to each other, properties of raw materials are significantly different form one another. Since the evaluation model generating apparatus 100 according to the present embodiment determines whether to generate an evaluation model based on similarity of properties of raw materials, it can be appropriately determined whether to generate an evaluation model even in such a case.

Further, the evaluation model generating apparatus 100 according to the present embodiment may judge, if a target raw material belongs in a cluster different from that of a raw material that has been used in the past as a result of clustering property data, that the target raw material is not similar in property to the raw material that has been used in the past. In this manner, the evaluation model generating apparatus 100 according to the present embodiment can judge similarity of properties of raw materials, which is relatively difficult to judge, by a clear criterion of whether they belong in the same cluster.

Yet further, if a data-to-data distance between property data of a target raw material and any one or more clusters, in which property data of raw materials that have been used in the past are grouped by hierarchical clustering, is a predetermined threshold value or more, the evaluation model generating apparatus 100 according to the present embodiment may judge that the target raw material is not similar in property to the raw material that has been used in the past. In this manner, the evaluation model generating apparatus 100 according to the present embodiment can judge similarity of properties of raw materials by a relatively simple criterion while clarifying the classification process.

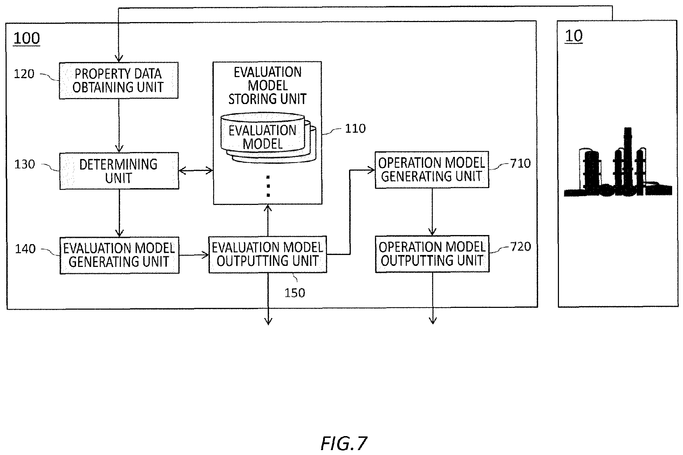

Fig. 7 illustrates one example of a block diagram of an evaluation model generating apparatus 100 according to a first modified example of the present embodiment, together with equipment 10. In Fig. 7, members having the same functions and structure as those in Fig. 1 are denoted by the same reference numerals, and description thereof will be omitted except for differences. In the embodiment described above, a case has been shown by way of example in which the evaluation model generating apparatus 100, the operation model generating apparatus, and the control apparatus are provided as separate and independent apparatuses. However, these apparatuses may be partially or fully integrated and provided as one apparatus. In this modified example, the evaluation model generating apparatus 100 provides a function of an operation model generating apparatus, in addition to the function of the evaluation model generating apparatus 100 according to the embodiment described above.

The evaluation model generating apparatus 100 according to this modified example may further include an operation model generating unit 710, and an operation model outputting unit 720.

The operation model generating unit 710 generates an operation model for outputting an action corresponding to a state of the equipment 10 by reinforcement learning in which an output of an evaluation model is treated as at least a part of a reward. For example, the operation model generating unit 710 may generate the operation model by obtaining an evaluation model output by an evaluation model outputting unit 150, and performing the reinforcement learning while treating an output of this evaluation model as at least a part of a reward.

Such an operation model may have a data table composed of, by way of example, a combination (S, A) of which S represents a set of sampled state data and A being an action taken under each state, and W being a weight calculate by a reward. Note that, the output of the evaluation model may be used as at least a part of a reward for calculating such a weight W.

In generating such an operation model, the operation model generating unit 710 may obtain learning environment data representing a state of a learning environment. At this time, if a simulator which simulates an operation in the equipment 10 is used as the learning environment, the operation model generating unit 710 may obtain simulation data from the simulator as the learning environment data. An actual equipment 10 can also be used as the learning environment. In this case, the operation model generating unit 710 may obtain state data representing a state of the equipment 10 as the learning environment data.

Next, the operation model generating unit 710 may decide an action randomly, or by using a known Al algorithm such as FKDPP that will be described below, and provide a control target in the learning environment with a manipulated variable based on this action. The state of the learning environment changes in response to this.

Then, the operation model generating unit 710 may obtain learning environment data again. In this manner, the operation model generating unit 710 can obtain a state of the learning environment after it has changed in response to the manipulated variable according to the decided action is provided to the control target.

Then, the operation model generating unit 710 may calculate a reward value based at least partially on the output of the evaluation model. By way of example, the operation model generating unit 710 may calculate, in response to learning environment data representing the state of learning environment after being changed being input into an evaluation model, an indicator output by this evaluation model as a reward value as it is.

The operation model generating unit 710 may not only overwrite a value in a weight column in the data table after repeating the obtaining processing of a state for multiple times according to the decision of such an action, but also update the operation model by adding new sample data that has not been saved previously to a new row in the data table. The operation model generating unit 710 can generate an operation model by repeating such updating processing for multiple times. Generation itself of the operation model may be arbitrarily performed, and thus further details are omitted from description herein. The operation model generating unit 710 supplies the operation model outputting unit 720 with the generated operation model.

The operation model outputting unit 720 outputs the operation model. For example, the operation model outputting unit 720 may output the operation model generated by the operation model generating unit 710 by transmitting the same to another apparatus via a network. Specifically, the operation model outputting unit 720 may transmit the generated operation model to a control apparatus. In response to this, the control apparatus may control a control target provided in the equipment 10 by using the operation model. The operation model outputting unit 720 can output the generated operation model by writing it to various memory devices, or by displaying it on a monitor.

In this manner, the evaluation model generating apparatus 100 according to this modified example can also generate an operation model by performing reinforcement learning in which an output of an evaluation model generated by machine learning is treated as at least a part of a reward. Accordingly, the evaluation model generating apparatus 100 according to this modified example can actualize a function of generating an evaluation model, and a function of generating an operation model by one apparatus. Therefore, because there is no need of communication between an evaluation model generating apparatus 100 and an operation model generating apparatus for an evaluation model, the evaluation model generating apparatus 100 according to this modified example can also reduce communication cost and communication time.

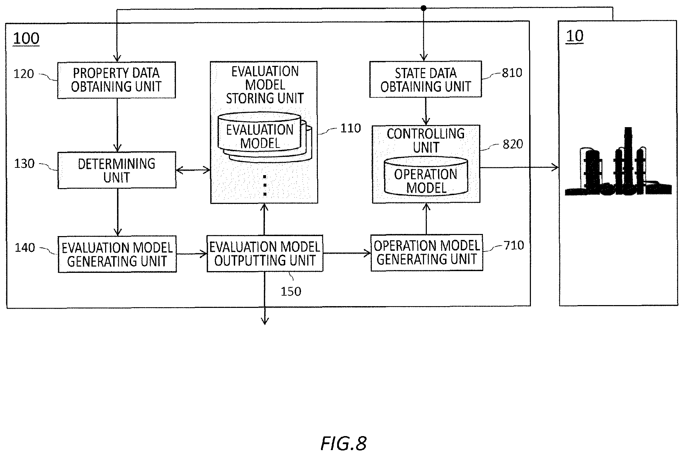

Fig. 8 illustrates one example of a block diagram of an evaluation model generating apparatus 100 according to a second modified example of the present embodiment, together with equipment 10. In Fig. 8, members having the same functions and structure as those in Fig. 7 are denoted by the same reference numerals, and description thereof will be omitted except for differences. In the first modified example, a case has been shown by way of example in which, the evaluation model generating apparatus 100 provides the function of the operation model generating apparatus. However, in this modified example, the evaluation model generating apparatus 100 provides a function of a control apparatus in addition to a function of an operation model generating apparatus.

The evaluation model generating apparatus 100 according to this modified example may further include a state data obtaining unit 810, and a controlling unit 820, instead of an operation model outputting unit 720. An operation model generating unit 710 may supply the controlling unit 820 with a generated operation model.

The state data obtaining unit 810 obtains state data representing a state of the equipment 10. For example, the state data obtaining unit 810 may obtain as the state data, various physical quantities measured by various types of sensors provided in the equipment 10 in times series, from the equipment 10 via a network. The state data obtaining unit 810 can obtain the state data through another means, such as a user input, various memory devices, or the like, or from another apparatus different from the equipment 10. The state data obtaining unit 810 supplies the controlling unit 820 with the obtained state data.

The controlling unit 820 controls a control target in the equipment 10 by using an operation model. For example, the controlling unit 820 may decide an action by using a known Al algorithm such as FKDPP. When using such a kernel method, the controlling unit 820 may generate a vector of a state S from a sensor value obtained by the obtained state data. Next, the controlling unit 820 may generate combinations of the state S and all possible actions A as an action decision table. Then, the controlling unit 820 may input the action decision table into an operation model. In response to this, the operation model may perform a kernel calculation between each row of the action decision table and each sample data in a data table excluding weight columns, and calculate a distance between each sample data. Next, the operation model may sequentially add distances calculated for the each sample data multiplied by a value of each weight column, and thereby calculate an expected reward value for each action. Then, the operation model may output an action that has the highest expected reward value among all possible actions. The controlling unit 820 may decide an action by selecting an action output by the operation model in this manner, for example.

Then, the controlling unit 820 may provide the control target with a manipulated variable obtained by adding the decided action to a current value of the control target, i.e., a current valve opening degree, for example. In this manner for example, the controlling unit 820 can perform Al control on the control target by using the operation model generated.

In this manner, the evaluation model generating apparatus 100 according to this modified example can control the control target by using the operation model generated by the reinforcement learning. Accordingly, the evaluation model generating apparatus 100 according to this modified example can actualize a function of generating an evaluation model, and a function of generating an operation model, and a function of controlling a control target by one apparatus. Therefore, because there is no need of communication between an evaluation model generating apparatus 100 and an operation model generating apparatus for an evaluation model, and between the operation model generating apparatus and a control apparatus for an operation model, the evaluation model generating apparatus 100 according to this modified example can further reduce communication cost and communication time.

Various embodiments that can be implemented have been described above with examples. However, the embodiments described above can be modified or applied in various ways. For example, in the embodiment described above, a case has been shown by way of example in which the number of evaluation models is not taken into consideration. That is, if the evaluation model generating apparatus 100 judges that a target raw material is not similar in property to any raw materials that have been used in the past, the evaluation model generating apparatus 100 generates an evaluation model without depending on the number of evaluation models having been stored in the evaluation model storing unit 110. However, in this case, it can be considered that a storage capacity of the evaluation model storing unit 110 is squeezed because a new evaluation model is added every time it is judged that a target raw material is not similar in property to a raw material that has been used in the past.

Therefore, an evaluation model generating apparatus 100 may have an upper limit value to the number of evaluation models that can be stored in the evaluation model storing unit 110. In this case, the determining unit 130 may perform, between step S450 and step S460, processing for confirming whether the number of evaluation models having been stored in the evaluation model storing unit 110 has reached the upper limit value. Then, if the number of evaluation models has not reached the upper limit value, the evaluation model generating apparatus 100 may cause the processing to proceed to step S460.

On the other hand, if the number of evaluation models has reached the upper limit value, the evaluation model generating apparatus 100 may cause the processing to proceed to step S465. Instead of this, if the number of evaluation models has reached the upper limit value, the evaluation model generating apparatus 100 may select one evaluation model among the evaluation models having been stored in the evaluation model storing unit 110, and after deleting the selected evaluation model, cause the processing to proceed to step S460.

Note that, in selecting the evaluation model to delete, the evaluation model generating apparatus 100 may select the evaluation model to delete via a user input, for example, automatically select an evaluation model with the oldest generation date or the oldest final date of use.

Also, the evaluation model generating apparatus 100 may cause, prior to deleting the evaluation model, the selected evaluation model to be backed up by transmitting it to another apparatus by the evaluation model outputting unit 150.

Various embodiments of the present invention may be described with reference to flowcharts and block diagrams, whose blocks may represent (1) steps of processes in which operations are executed or (2) sections of apparatuses responsible for executing operations. Certain steps and sections may be implemented by a dedicated circuit, a programmable circuit supplied with a computer readable instruction stored on a computer readable medium, and/or a processor supplied with a computer readable instruction stored on a computer readable medium. The dedicated circuit may include digital and/or analog hardware circuits, and may include integrated circuits (IC) and/or discrete circuits. The programmable circuit may include a reconfigurable hardware circuit including logical AND, logical OR, logical XOR, logical NAND, logical NOR, and other logical operations, a memory element such as a flip-flop, a register, a field programmable gate array (FPGA) and a programmable logic array (PLA), and the like.

The computer readable medium may include any tangible device that can store instructions to be executed by a suitable device, and as a result, the computer readable medium having instructions stored thereon includes a product including instructions which can be executed to create means for performing operations specified in the flowcharts or block diagrams. Examples of the computer readable medium may include an electronic storage medium, a magnetic storage medium, an optical storage medium, an electromagnetic storage medium, a semiconductor storage medium, and the like. More specific examples of the computer readable medium may include a floppy (registered trademark) disk, a diskette, a hard disk, a random access memory (RAM), a read-only memory (ROM), an erasable programmable read-only memory (EPROM or flash memory), an electrically erasable programmable read-only memory (EEPROM), a static random access memory (SRAM), a compact disc read-only memory (CD-ROM), a digital versatile disk (DVD), a Blu-ray (registered trademark) disk, a memory stick, an integrated circuit card, and the like.

The computer readable instruction may include: an assembler instruction, an instruction-set-architecture (ISA) instruction; a machine instruction; a machine dependent instruction; a microcode; a firmware instruction; state-setting data; or either a source code or an object code written in any combination of one or more programming languages, including an object oriented programming language such as Smalltalk (registered trademark), JAVA (registered trademark), C++, or the like; and a conventional procedural programming language such as a "C" programming language or a similar programming language.

Computer readable instructions may be provided to a processor of a general purpose computer, special purpose computer, or other programmable data processing apparatuses, or to a programmable circuit, locally or via a local area network (LAN), wide area network (WAN) such as the Internet, or the like, to execute the computer readable instructions to create means for performing operations specified in the flowcharts or block diagrams. Examples of the processor include a computer processor, a processing unit, a microprocessor, a digital signal processor, a controller, a microcontroller, and the like.

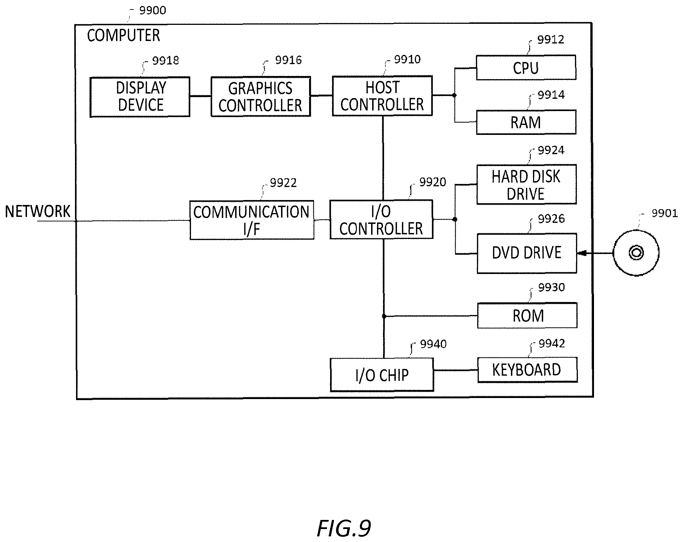

Fig. 9 illustrates an example of a computer 9900 where a plurality of aspects of the present invention may be entirely or partially embodied. A program that is installed in the computer 9900 can cause the computer 9900 to function as an operation associated with the apparatus according to the embodiment of the present invention or one or more sections of this apparatus, or cause the computer 9900 to execute this operation or this one or more sections, and/or cause the computer 9900 to execute a process according to the embodiment of the present invention or a step of this process. Such a program may be executed by a CPU 9912 so as to cause the computer 9900 to execute certain operations associated with some or all of the flowcharts and the blocks in the block diagrams described in this specification.

The computer 9900 according to the present embodiment includes the CPU 9912, a RAM 9914, a graphic controller 9916 and a display device 9918, which are mutually connected by a host controller 9910. The computer 9900 further includes input/output units such as a communication interface 9922, a hard disk drive 9924, a DVD drive 9926 and an IC card drive, which are connected to the host controller 9910 via an input/output controller 9920. The computer also includes legacy input/output units such as a ROM 9930 and a keyboard 9942, which are connected to the input/output controller 9920 via an input/output chip 9940.

The CPU 9912 operates according to programs stored in the ROM 9930 and the RAM 9914, thereby controlling each unit. The graphic controller 9916 obtains image data generated by the CPU 9912 on a frame buffer or the like provided in the RAM 9914 or in itself, and to cause the image data to be displayed on the display device 9918.

The communication interface 9922 communicates with other electronic devices via a network. The hard disk drive 9924 stores programs and data that are used by the CPU 9912 within the computer 9900. The DVD drive 9926 reads programs or data from a DVD-ROM 9901, and to provide the hard disk drive 9924 with the programs or data via the RAM 9914. The IC card drive reads the programs and the data from the IC card, and/or writes the programs and the data to the IC card.

The ROM 9930 stores therein a boot program or the like executed by the computer 9900 at the time of activation, and/or a program depending on the hardware of the computer 9900. The input/output chip 9940 may also connect various input/output units via a parallel port, a serial port, a keyboard port, a mouse port or the like to the input/output controller 9920.

A program is provided by a computer readable medium such as the DVD-ROM 9901 or the IC card. The program is read from the computer readable medium, installed into the hard disk drive 9924, RAM 9914, or ROM 9930, which are also examples of a computer readable medium, and executed by CPU 9912. The information processing described in these programs is read into the computer 9900, resulting in cooperation between a program and the above-mentioned various types of hardware resources. An apparatus or method may be constituted by actualizing the operation or processing of information in accordance with the usage of the computer 9900.

For example, when communication is performed between the computer 9900 and an external device, the CPU 9912 may execute a communication program loaded onto the RAM 9914 to instruct communication processing to the communication interface 9922, based on the processing described in the communication program. The communication interface 9922, under control of the CPU 9912, reads transmission data stored on a transmission buffer processing region provided in a recording medium such as the RAM 9914, the hard disk drive 9924, DVD-ROM 9901, or the IC card, and transmits the read transmission data to a network or writes reception data received from a network to a reception buffer processing region or the like provided on the recording medium.

Also, the CPU 9912 may cause all or a necessary portion of a file or a database to be read into the RAM 9914, wherein the file or the database has been stored in an external recording medium such as the hard disk drive 9924, the DVD drive 9926 (DVD-ROM 9901), the IC card, etc., and perform various types of processing on the data on the RAM 9914. The CPU 9912 then writes back the processed data to the external recording medium.

Various types of information such as various types of programs, data, tables, and databases may be stored in a recording medium and subjected to information processing. The CPU 9912 may perform various types of processing on the data read from the RAM 9914, which includes various types of operations, information processing, conditional judging, conditional branch, unconditional branch, search/replacement of information, etc., as described throughout this disclosure and designated by an instruction sequence of programs, and writes the result back to the RAM 9914. Also the CPU 9912 may search for information in a file, a database, etc., in the recording medium. For example, when a plurality of entries, each having an attribute value of a first attribute associated with an attribute value of a second attribute, are stored in the recording medium, the CPU 9912 may search for an entry whose attribute value of the first attribute matches the condition a designated condition, from among this plurality of entries, and read the attribute value of the second attribute stored in this entry, thereby obtaining the attribute value of the second attribute associated with the first attribute satisfying the predetermined condition.

The above described program or software modules may be stored in the computer readable medium on or near the computer 9900. Also a recording medium such as a hard disk or a RAM provided in a server system connected to a dedicated communication network or the Internet can be used as the computer readable medium, thereby providing the program to the computer 9900 via the network.

### EXPLANATION OF REFERENCES

10: equipment;
100: evaluation model generating apparatus;
110: evaluation model storing unit;
120: property data obtaining unit;
130: determining unit;
140: evaluation model generating unit;
150: evaluation model outputting unit;
710: operation model generating unit;
720: operation model outputting unit;
810: state data obtaining unit;
820: controlling unit;
9900: computer;
9901: DVD-ROM;
9910: host controller;
9912: CPU;
9914: RAM;
9916: graphic controller;
9918: display device;
9920: input/output controller;
9922: communication interface;
9924: hard disk drive;
9926: DVD drive;
9930: ROM;
9940: input/output chip;
9942: keyboard.

## Claims

1. An evaluation model generating apparatus (100), comprising:
a property data obtaining unit (120) configured to obtain, from an equipment via a network, or through a user input or a memory device, or from another apparatus different from the equipment, property data representing a property of a raw material, the raw material to be used by the equipment that manufactures a product from the raw material;
a determining unit (130) configured to determine, based on the property data, whether to generate an evaluation model that outputs an indicator obtained by evaluating a state of the equipment;
an evaluation model generating unit (140) configured to generate, according to a result of the determining, the evaluation model by machine learning;
an evaluation model outputting unit (150) configured to output the generated evaluation model;
an operation model generating unit (710) configured to generate an operation model that outputs an action according to a state of the equipment, by obtaining the evaluation model output by the evaluation model outputting unit (150), and performing reinforcement learning in which an output of the evaluation model is treated as a reward value; and
a controlling unit (820) configured to control a control target in the equipment by using the operation model, wherein
the determining unit (130) is configured to determine, if it is judged that a target raw material is not similar in property to a raw material that has been used in a past when the target raw material belongs in a cluster different from that of the raw material that has been used in the past as a result of clustering the property data, to generate the evaluation model, and determine, if it is judged that a target raw material is similar in property to a raw material that has been used in a past when the target raw material does not belong in a cluster different from that of the raw material that has been used in the past as a result of clustering the property data, not to generate the evaluation model.

2. The evaluation model generating apparatus (100) according to claim 1, wherein the determining unit (130) is configured to judge, if a data-to-data distance between the property data of the target raw material and any one or more clusters, in which the property data of the raw material that has been used in the past is grouped by hierarchical clustering, is a predetermined threshold value or more, that the target raw material is not similar in property to the raw material that has been used in the past.

3. The evaluation model generating apparatus (100) according to claim 1 or 2, wherein the raw material includes at least crude oil.

4. The evaluation model generating apparatus (100) according to claim 3, wherein the property data has data representing at least one of a chemical property, or a physical property of the crude oil.

5. The evaluation model generating apparatus (100) according to claim 4, wherein the chemical property includes at least any of a carbon content, hydrogen content, sulfur content, nitrogen content, oxygen content, or metal content.

6. The evaluation model generating apparatus (100) according to claim 4, wherein the chemical property includes a type of molecular structure of hydrocarbons.

7. The evaluation model generating apparatus (100) according to claim 4, wherein the physical property includes at least any of a specific gravity, vapor pressure, kinematic viscosity, or pour point.

8. The evaluation model generating apparatus (100) according to claim 1 or 2, wherein the raw material includes at least one of fossil fuel or water.

9. An evaluation model generating method executed by a computer, the method comprising that the computer:
obtains, from an equipment via a network, or through a user input or a memory device, or from another apparatus different from the equipment, property data representing a property of a raw material, the raw material to be used by the equipment that manufactures a product from the raw material;
determines, based on the property data, whether to generate an evaluation model that outputs an indicator obtained by evaluating a state of the equipment;
generates the evaluation model by machine learning according to a result of the determining; and
outputs the generated evaluation model;
generates an operation model that outputs an action according to a state of the equipment, by obtaining the evaluation model, and performing reinforcement learning in which an output of the evaluation model is treated as a reward value; and
controls a control target in the equipment by using the operation model, wherein
the determining includes determining, if it is judged that a target raw material is not similar in property to a raw material that has been used in a past when the target raw material belongs in a cluster different from that of the raw material that has been used in the past as a result of clustering the property data, to generate the evaluation model, and determining, if it is judged that a target raw material is similar in property to a raw material that has been used in a past when the target raw material does not belong in a cluster different from that of the raw material that has been used in the past as a result of clustering the property data, not to generate the evaluation model.

10. An evaluation model generating program executed by a computer, wherein the evaluation model generating program causes the computer to function as:
a property data obtaining unit (120) configured to obtain, from an equipment via a network, or through a user input or a memory device, or from another apparatus different from the equipment, property data representing a property of a raw material, the raw material to be used by the equipment that manufactures a product from the raw material;
a determining unit (130) configured to determine, based on the property data, whether to generate an evaluation model that outputs an indicator obtained by evaluating a state of the equipment;
an evaluation model generating unit (140) configured to generate, according to a result of the determining, the evaluation model by machine learning; and
an evaluation model outputting unit (150) configured to output the generated evaluation model;
an operation model generating unit (710) configured to generate an operation model that outputs an action according to a state of the equipment, by obtaining the evaluation model output by the evaluation model outputting unit (150), and performing reinforcement learning in which an output of the evaluation model is treated as a reward value;
a controlling unit (820) configured to control a control target in the equipment by using the operation model, wherein
the determining unit (130) is configured to determine, if it is judged that a target raw material is not similar in property to a raw material that has been used in a past when the target raw material belongs in a cluster different from that of the raw material that has been used in the past as a result of clustering the property data, to generate the evaluation model, and determine, if it is judged that a target raw material is similar in property to a raw material that has been used in a past when the target raw material does not belong in a cluster different from that of the raw material that has been used in the past as a result of clustering the property data, not to generate the evaluation model.

11. A computer readable recording medium storing the program according to claim 10.

## Patentansprüche

1. Einrichtung zur Erzeugung eines Auswertungsmodells (100), umfassend:
eine Einheit zum Erhalten von Eigenschaftsdaten (120), die ausgebildet ist, um von einer Ausrüstung über ein Netzwerk, oder durch eine Benutzereingabe oder eine Speichervorrichtung, oder von einer anderen Einrichtung, die sich von der Ausrüstung unterscheidet, Eigenschaftsdaten zu erhalten, die eine Eigenschaft eines Rohmaterials darstellen, wobei das Rohmaterial von der Ausrüstung zu verwenden ist, die ein Produkt aus dem Rohmaterial herstellt;
eine Bestimmungseinheit (130), die ausgebildet ist, um basierend auf den Eigenschaftsdaten zu bestimmen, ob ein Auswertungsmodell erzeugt werden soll, das einen Indikator ausgibt, der durch Auswerten eines Zustands der Ausrüstung erhalten wird;
eine Einheit zum Erzeugen eines Auswertungsmodells (140), die ausgebildet ist, um gemäß einem Ergebnis der Bestimmung das Auswertungsmodell durch maschinelles Lernen zu erzeugen;
eine Einheit zum Ausgeben eines Auswertungsmodells (150), die ausgebildet ist, um das erzeugte Auswertungsmodell auszugeben;
eine Einheit zum Erzeugen eines Betriebsmodells (710), die ausgebildet ist, um ein Betriebsmodell zu erzeugen, das eine Aktion gemäß einem Zustand der Ausrüstung ausgibt, indem sie das von der Einheit zum Ausgeben eines Auswertungsmodells (150) ausgegebene Auswertungsmodell erhält und Verstärkungslernen durchführt, bei dem eine Ausgabe des Auswertungsmodells als Belohnungswert behandelt wird; und
eine Steuereinheit (820), die ausgebildet ist, um ein Steuerziel in der Ausrüstung durch Verwenden des Betriebsmodells zu steuern, wobei
die Bestimmungseinheit (130), falls beurteilt wird, dass ein Zielrohmaterial hinsichtlich einer Eigenschaft einem in einer Vergangenheit verwendeten Rohmaterial nicht ähnlich ist, wenn das Zielrohmaterial zu einem Cluster gehört, der sich von jenem des in der Vergangenheit verwendeten Rohmaterials als Ergebnis von Clustering der Eigenschaftsdaten unterscheidet, ausgebildet ist, um zu bestimmen, ob das Auswertungsmodell erzeugt werden soll, und zu bestimmen, falls beurteilt wird, dass ein Zielrohmaterial hinsichtlich einer Eigenschaft einem in einer Vergangenheit verwendeten Rohmaterial ähnlich ist, wenn das Zielrohmaterial nicht zu einem Cluster gehört, der sich von jenem des in der Vergangenheit verwendeten Rohmaterials als Ergebnis von Clustering der Eigenschaftsdaten unterscheidet, das Auswertungsmodell nicht zu erzeugen.

2. Einrichtung zur Erzeugung eines Auswertungsmodells (100) nach Anspruch 1, wobei die Bestimmungseinheit (130), falls ein Abstand zwischen Daten zwischen den Eigenschaftsdaten des Zielrohmaterials und einem beliebigen oder mehreren Clustern, in denen die Eigenschaftsdaten des in der Vergangenheit verwendeten Rohmaterials durch hierarchisches Clustering gruppiert sind, ein vorbestimmter Schwellenwert oder mehr ist, ausgebildet ist, zu beurteilen, dass das Zielrohmaterial hinsichtlich einer Eigenschaft dem in der Vergangenheit verwendeten Rohmaterial nicht ähnlich ist.

3. Einrichtung zur Erzeugung eines Auswertungsmodells (100) nach Anspruch 1 oder 2, wobei das Rohmaterial zumindest Erdöl einschließt.

4. Einrichtung zur Erzeugung eines Auswertungsmodells (100) nach Anspruch 3, wobei die Eigenschaftsdaten Daten aufweisen, die zumindest eine von einer chemischen Eigenschaft oder einer physikalischen Eigenschaft des Erdöls darstellen.

5. Einrichtung zur Erzeugung eines Auswertungsmodells (100) nach Anspruch 4, wobei die chemische Eigenschaft zumindest eines von Kohlenstoffgehalt, Wasserstoffgehalt, Schwefelgehalt, Stickstoffgehalt, Sauerstoffgehalt oder Metallgehalt einschließt.

6. Einrichtung zur Erzeugung eines Auswertungsmodells (100) nach Anspruch 4, wobei die chemische Eigenschaft eine Art der Molekularstruktur von Kohlenwasserstoffen einschließt.

7. Einrichtung zur Erzeugung eines Auswertungsmodells (100) nach Anspruch 4, wobei die physikalische Eigenschaft zumindest eines von spezifischem Gewicht, Dampfdruck, kinematischer Viskosität oder Fließpunkt einschließt.

8. Einrichtung zur Erzeugung eines Auswertungsmodells (100) nach Anspruch 1 oder 2, wobei das Rohmaterial zumindest eines von fossilem Brennstoff oder Wasser einschließt.

9. Verfahren zum Erzeugen eines Auswertungsmodells, das von einem Computer ausgeführt wird, wobei das Verfahren umfasst, dass der Computer:
von einer Ausrüstung über ein Netzwerk, oder durch eine Benutzereingabe oder eine Speichervorrichtung, oder von einer anderen Einrichtung, die sich von der Ausrüstung unterscheidet, Eigenschaftsdaten erhält, die eine Eigenschaft eines Rohmaterials darstellen, wobei das Rohmaterial von der Ausrüstung zu verwenden ist, die ein Produkt aus dem Rohmaterial herstellt;
basierend auf den Eigenschaftsdaten bestimmt, ob ein Auswertungsmodell erzeugt werden soll, das einen Indikator ausgibt, der durch Auswerten eines Zustands der Ausrüstung erhalten wird;
gemäß einem Ergebnis der Bestimmung das Auswertungsmodell durch maschinelles Lernen erzeugt; und
das erzeugte Auswertungsmodell ausgibt;
ein Betriebsmodell erzeugt, das eine Aktion gemäß einem Zustand der Ausrüstung ausgibt, indem er das Auswertungsmodell erhält und Verstärkungslernen durchführt, bei dem eine Ausgabe des Auswertungsmodells als Belohnungswert behandelt wird; und
ein Steuerziel in der Ausrüstung durch Verwenden des Betriebsmodells steuert, wobei
das Bestimmen einschließt, falls beurteilt wird, dass ein Zielrohmaterial hinsichtlich einer Eigenschaft einem in einer Vergangenheit verwendeten Rohmaterial nicht ähnlich ist, wenn das Zielrohmaterial zu einem Cluster gehört, der sich von jenem des in der Vergangenheit verwendeten Rohmaterials als Ergebnis von Clustering der Eigenschaftsdaten unterscheidet, zu bestimmen, das Auswertungsmodell zu erzeugen, und zu bestimmen, falls beurteilt wird, dass ein Zielrohmaterial hinsichtlich einer Eigenschaft einem in einer Vergangenheit verwendeten Rohmaterial ähnlich ist, wenn das Zielrohmaterial nicht zu einem Cluster gehört, der sich von jenem des in der Vergangenheit verwendeten Rohmaterials als Ergebnis von Clustering der Eigenschaftsdaten unterscheidet, das Auswertungsmodell nicht zu erzeugen.

10. Programm zum Erzeugen eines Auswertungsmodells, das von einem Computer ausgeführt wird, wobei das Programm zum Erzeugen eines Auswertungsmodells bewirkt, dass der Computer fungiert als:
eine Einheit zum Erhalten von Eigenschaftsdaten (120), die ausgebildet ist, um von einer Ausrüstung über ein Netzwerk, oder durch eine Benutzereingabe oder eine Speichervorrichtung, oder von einer anderen Einrichtung, die sich von der Ausrüstung unterscheidet, Eigenschaftsdaten zu erhalten, die eine Eigenschaft eines Rohmaterials darstellen, wobei das Rohmaterial von einer Ausrüstung zu verwenden ist, die ein Produkt aus dem Rohmaterial herstellt;
eine Bestimmungseinheit (130), die ausgebildet ist, um basierend auf den Eigenschaftsdaten zu bestimmen, ob ein Auswertungsmodell erzeugt werden soll, das einen Indikator ausgibt, der durch Auswerten eines Zustands der Ausrüstung erhalten wird;
eine Einheit zum Erzeugen eines Auswertungsmodells (140), die ausgebildet ist, um gemäß einem Ergebnis der Bestimmung das Auswertungsmodell durch maschinelles Lernen zu erzeugen; und
eine Einheit zum Ausgeben eines Auswertungsmodells (150), die ausgebildet ist, um das erzeugte Auswertungsmodell auszugeben;
eine Einheit zum Erzeugen eines Betriebsmodells (710), die ausgebildet ist, um ein Betriebsmodell zu erzeugen, das eine Aktion gemäß einem Zustand der Ausrüstung ausgibt, indem sie das von der Einheit zum Ausgeben eines Auswertungsmodells (150) ausgegebene Auswertungsmodell erhält und Verstärkungslernen durchführt, bei dem eine Ausgabe des Auswertungsmodells als Belohnungswert behandelt wird;
eine Steuereinheit (820), die ausgebildet ist, um ein Steuerziel in der Ausrüstung durch Verwenden des Betriebsmodells zu steuern, wobei
eine Bestimmungseinheit (130), falls beurteilt wird, dass ein Zielrohmaterial hinsichtlich einer Eigenschaft einem in einer Vergangenheit verwendeten Rohmaterial nicht ähnlich ist, wenn das Zielrohmaterial zu einem Cluster gehört, der sich von jenem des in der Vergangenheit verwendeten Rohmaterials als Ergebnis von Clustering der Eigenschaftsdaten unterscheidet, ausgebildet ist, um zu bestimmen, das Auswertungsmodell zu erzeugen, und zu bestimmen, falls beurteilt wird, dass ein Zielrohmaterial hinsichtlich einer Eigenschaft einem in einer Vergangenheit verwendeten Rohmaterial ähnlich ist, wenn das Zielrohmaterial nicht zu einem Cluster gehört, der sich von jenem des in der Vergangenheit verwendeten Rohmaterials als Ergebnis von Clustering der Eigenschaftsdaten unterscheidet, das Auswertungsmodell nicht zu erzeugen.

11. Computerlesbares Aufzeichnungsmedium, das das Programm nach Anspruch 10 speichert.

## Revendications

1. Appareil (100) de génération de modèle d'évaluation, comprenant :
une unité (120) d'obtention de données de propriété configurée pour obtenir, à partir d'un équipement par l'intermédiaire d'un réseau, ou par l'intermédiaire d'une entrée d'utilisateur ou d'un dispositif de mémoire, ou à partir d'un autre appareil différent de l'équipement, des données de propriété représentant une propriété d'une matière première, la matière première devant être utilisée par l'équipement qui fabrique un produit à partir de la matière première ;
une unité de détermination (130) configurée pour déterminer, sur la base des données de propriété, s'il convient de générer un modèle d'évaluation qui produit un indicateur obtenu par évaluation d'un état de l'équipement ;
une unité (140) de génération de modèle d'évaluation configurée pour générer, selon un résultat de la détermination, le modèle d'évaluation par apprentissage automatique ;
une unité (150) de production de modèle d'évaluation configurée pour produire le modèle d'évaluation généré ;
une unité (710) de génération de modèle de fonctionnement configurée pour générer un modèle de fonctionnement qui produit une action selon un état de l'équipement, en obtenant le modèle d'évaluation produit par l'unité (150) de production de modèle d'évaluation, et en réalisant un apprentissage par renforcement dans lequel une production du modèle d'évaluation est traitée comme une valeur de récompense ; et
une unité de commande (820) configurée pour commander une cible de commande dans l'équipement en utilisant le modèle de fonctionnement, dans lequel
l'unité de détermination (130) est configurée pour déterminer, s'il est estimé qu'une matière première cible n'est pas similaire en propriété à une matière première qui a été utilisée dans un passé lorsque la matière première cible appartient à un groupe différent de celui de la matière première qui a été utilisée dans le passé comme un résultat de regroupement des données de propriété, la génération du modèle d'évaluation, et déterminer, s'il est estimé qu'une matière première cible est similaire en propriété à une matière première qui a été utilisée dans un passé lorsque la matière première cible n'appartient pas à un groupe différent de celui de la matière première qui a été utilisée dans le passé comme un résultat de regroupement des données de propriété, l'absence de génération du modèle d'évaluation.

2. Appareil (100) de génération de modèle d'évaluation selon la revendication 1, dans lequel l'unité de détermination (130) est configurée pour estimer, si une distance donnée à donnée entre les données de propriété de la matière première cible et un quelconque ou plusieurs quelconques groupes, dans lesquels les données de propriété de la matière première qui a été utilisée dans le passé sont regroupées par regroupement hiérarchique, est une valeur seuil prédéterminée ou plus, que la matière première cible n'est pas similaire en propriété à la matière première qui a été utilisée dans le passé.

3. Appareil (100) de génération de modèle d'évaluation selon la revendication 1 ou la revendication 2, dans lequel la matière première inclut au moins du pétrole brut.

4. Appareil (100) de génération de modèle d'évaluation selon la revendication 3, dans lequel les données de propriété présentent des données représentant au moins l'une d'une propriété chimique ou d'une propriété physique du pétrole brut.

5. Appareil (100) de génération de modèle d'évaluation selon la revendication 4, dans lequel la propriété chimique inclut au moins l'une quelconque parmi une teneur en carbone, une teneur en hydrogène, une teneur en soufre, une teneur en azote, une teneur en oxygène, ou une teneur en métal.

6. Appareil (100) de génération de modèle d'évaluation selon la revendication 4, dans lequel la propriété chimique inclut un type de structure moléculaire d'hydrocarbures.

7. Appareil (100) de génération de modèle d'évaluation selon la revendication 4, dans lequel la propriété physique inclut au moins l'un ou l'une quelconque parmi une gravité spécifique, une pression de vapeur, une viscosité cinématique, ou un point d'écoulement.

8. Appareil (100) de génération de modèle d'évaluation selon la revendication 1 ou la revendication 2, dans lequel la matière première inclut au moins l'un ou l'une d'un combustible fossile ou d'eau.

9. Procédé de génération de modèle d'évaluation exécuté par un ordinateur, le procédé comprenant le fait que l'ordinateur :
obtienne, à partir d'un équipement par l'intermédiaire d'un réseau, ou par l'intermédiaire d'une entrée d'utilisateur ou d'un dispositif de mémoire, ou à partir d'un autre appareil différent de l'équipement, des données de propriété représentant une propriété d'une matière première, la matière première devant être utilisée par l'équipement qui fabrique un produit à partir de la matière première ;
détermine, sur la base des données de propriété, s'il convient de générer un modèle d'évaluation qui produit un indicateur obtenu par évaluation d'un état de l'équipement ;
génère le modèle d'évaluation par apprentissage automatique selon un résultat de la détermination ; et
produise le modèle d'évaluation généré ;
génère un modèle de fonctionnement qui produit une action selon un état de l'équipement, en obtenant le modèle d'évaluation, et en réalisant un apprentissage par renforcement dans lequel une production du modèle d'évaluation est traitée comme une valeur de récompense ; et
commande une cible de commande dans l'équipement en utilisant le modèle de fonctionnement, dans lequel
la détermination inclut la détermination, s'il est estimé qu'une matière première cible n'est pas similaire en propriété à une matière première qui a été utilisée dans un passé lorsque la matière première cible appartient à un groupe différent de celui de la matière première qui a été utilisée dans le passé comme un résultat de regroupement des données de propriété, de générer le modèle d'évaluation, et la détermination, s'il est estimé qu'une matière première cible est similaire en propriété à une matière première qui a été utilisée dans un passé lorsque la matière première cible n'appartient pas à un groupe différent de celui de la matière première qui a été utilisée dans le passé comme un résultat de regroupement des données de propriété, de ne pas générer le modèle d'évaluation.

10. Programme de génération de modèle d'évaluation exécuté par un ordinateur, dans lequel le programme de génération de modèle d'évaluation amène l'ordinateur à fonctionner comme :
une unité (120) d'obtention de données de propriété configurée pour obtenir, à partir d'un équipement par l'intermédiaire d'un réseau, ou par l'intermédiaire d'une entrée d'utilisateur ou d'un dispositif de mémoire, ou à partir d'un autre appareil différent de l'équipement, des données de propriété représentant une propriété d'une matière première, la matière première devant être utilisée par l'équipement qui fabrique un produit à partir de la matière première ;
une unité de détermination (130) configurée pour déterminer, sur la base des données de propriété, s'il convient de générer un modèle d'évaluation qui produit un indicateur obtenu par évaluation d'un état de l'équipement ;
une unité (140) de génération de modèle d'évaluation configurée pour générer, selon un résultat de la détermination, le modèle d'évaluation par apprentissage automatique ; et
une unité (150) de production de modèle d'évaluation configurée pour produire le modèle d'évaluation généré ;
une unité (710) de génération de modèle de fonctionnement configurée pour générer un modèle de fonctionnement qui produit une action selon un état de l'équipement, en obtenant le modèle d'évaluation produit par l'unité (150) de production de modèle d'évaluation, et en réalisant un apprentissage par renforcement dans lequel une production du modèle d'évaluation est traitée comme une valeur de récompense ;
une unité de commande (820) configurée pour commander une cible de commande dans l'équipement en utilisant le modèle de fonctionnement, dans lequel
l'unité de détermination (130) est configurée pour déterminer, s'il est estimé qu'une matière première cible n'est pas similaire en propriété à une matière première qui a été utilisée dans un passé lorsque la matière première cible appartient à un groupe différent de celui de la matière première qui a été utilisée dans le passé comme un résultat de regroupement des données de propriété, la génération du modèle d'évaluation, et déterminer, s'il est estimé qu'une matière première cible est similaire en propriété à une matière première qui a été utilisée dans un passé lorsque la matière première cible n'appartient pas à un groupe différent de celui de la matière première qui a été utilisée dans le passé comme un résultat de regroupement des données de propriété, l'absence de génération du modèle d'évaluation.

11. Support d'enregistrement lisible par ordinateur stockant le programme selon la revendication 10.
